# EUROPEAN PATENT SPECIFICATION

(11) **EP 3 598 492 B1**
(45) Date of publication and mention of the grant of the patent: **26.07.2023**
(21) Application number: 18767802.4
(22) Date of filing: 07.03.2018
(51) Int. Cl.: H01L 25/075, H01L 33/48, H01L 21/683, H01L 21/67, H01L 33/62

(54) **METHOD FOR MANUFACTURING DISPLAY DEVICE**
VERFAHREN ZUR HERSTELLUNG EINER ANZEIGEVORRICHTUNG
PROCÉDÉ DE FABRICATION DE DISPOSITIF D'AFFICHAGE

(30) Priority: 13.03.2017 US 201762470499 P
(43) Date of publication of application: 22.01.2020
(73) Proprietor: Seoul Semiconductor Co., Ltd., Ansan-si, Gyeonggi-do 15429 (KR)
(72) Inventor: TAKEYA, Motonobu, Ansan-si Gyeonggi-do 15429 (KR)
(74) Representative: Stolmár & Partner Patentanwälte PartG mbB
(86) International application number: PCT/KR2018/002688
(87) International publication number: WO 2018/169243

(56) References cited:
- KR-A- 20100 045 980
- KR-A- 20120 087 505
- KR-A- 20140 095 794
- KR-A- 20140 108 228
- KR-A- 20150 074 321
- US-A1- 2005 233 504
- US-A1- 2012 313 241
- US-A1- 2015 372 187

## Description

### [Technical Field]

Exemplary embodiments of the present invention relate to a method of manufacturing a display apparatus, and, more particularly, to a method of manufacturing a display apparatus for transferring a light emitting diode chip included in the display apparatus to a substrate.

### [Background Art]

A light emitting diode refers to an inorganic semiconductor device that emits light through recombination of electrons and holes. In recent years, light emitting diodes have been used in various fields including displays, automobile lamps, general lighting, and the like. Light emitting diodes have various advantages, such as long lifespan, low power consumption, and rapid response. Thus, light emitting devices using a light emitting diode are replacing existing light sources quickly.

Recently, display apparatuses, such as TVs, monitors or electronic display boards, realize colors through a thin film transistor liquid crystal display (TFT-LCD) panel, and employ light emitting diodes as a light source of a backlight unit for emission of the realized colors. In addition, various studies have been conducted to develop a display apparatus capable of realizing colors through light emitting diodes instead of using an LCD.

In order to use light emitting diodes as a light source of a backlight unit or for direct realization of colors, one light emitting diode may be provided for each pixel. Here, in order to control each of the light emitting diodes, an active matrix (AM) drive type or a passive matrix (PM) drive type may be employed. For the AM drive type, it is sufficient for the luminous area of each light emitting diode to be 1/10,000 of the area of one pixel, and for the PM drive type, for the luminous area of each light emitting diode to be 1/100 of the area of one pixel.

By the way, light emitting diodes having an excessively large luminous area have a problem of low current density, causing deterioration in luminous efficacy. Therefore, light emitting diodes having a small luminous area in comparison with a pixel area are used, and thus the current density flowing through the light emitting diodes may be increased while satisfying the luminous efficacy in the pixel.

However, as the luminous area becomes smaller, the size of the light emitting diodes becomes smaller too. As a result, light emitting diodes having the small luminous area provide difficulty in mounting a number of light emitting diodes and replacing the light emitting diodes due to small sizes thereof.

In this regard, patent application US 2012/0313241 A1 discloses a method for selective transferring active components during a manufacturing process. The transfer includes repeated transfers between transfer substrates for flipping the active components.

Patent application US 2015/0372187 A1 is directed towards a method for preparing GaN materials and devices as to form display and lightning components on several native substrates and micro assembling them in an array on a common substrate.

In turn, patent application US 2005/0233504 A1 is in part dedicated to a method according to which devices arranged on a temporary holding substrate are embedded into and held in a pressure sensitive adhesive layer formed on the transfer substrate.

### [Disclosure of Invention]

### [Technical Problem]

Exemplary embodiments of the present disclosure provide a method of manufacturing a display apparatus using a light emitting diode package capable of increasing the yield of mounting and repairing a light emitting diode even when the light emitting diode having a small luminous area is used in comparison with a pixel area of the display apparatus.

### [Technical Solution]

A method of manufacturing a display apparatus not forming a part of the invention may include: forming a plurality of light emitting diode chips on a first manufacturing substrate; coupling the plurality of the light emitting diode chips onto a second manufacturing substrate; separating the first manufacturing substrate from the plurality of the light emitting diode chips; and transferring the plurality of light emitting diode chips coupled onto the second manufacturing substrate to a substrate on which a plurality of first and second substrate electrodes are disposed.

In addition, the method of manufacturing the display apparatus may further include: irradiating the first manufacturing substrate with a laser to separate the plurality of light emitting diode chips from the first manufacturing substrate when the plurality of light emitting diode chips are coupled to the second manufacturing substrate.

In this case, the transferring step may include: coupling the plurality of light emitting diode chips to a third manufacturing substrate; separating the second manufacturing substrate from the plurality of light emitting diode chips; coupling the plurality of light emitting diode chips to a plurality of first and second substrate electrodes; and separating the third manufacturing substrate from the plurality of light emitting diode chips.

Moreover, the second manufacturing substrate has elasticity, and the transferring step may further include elongating the second manufacturing substrate having elasticity, and, in the step of coupling the plurality of light emitting diode chips to the third manufacturing substrate, the plurality of light emitting diode chips disposed on the elongated second manufacturing substrate may be coupled to the third manufacturing substrate.

Further, the transferring step may include: adsorbing a portion of the plurality of light emitting diode chips coupled to the second manufacturing substrate with a transfer device; performing at least one of heating and ultrasonic-irradiating the second manufacturing substrate so as to separate the portion of the plurality of light emitting diode chips adsorbed on the transfer device from the second manufacturing substrate; coupling a portion of the absorbed plurality of light emitting diode chips to the substrate; and separating the transfer device from the plurality of light emitting diode chips coupled to the substrate.

Alternatively, the transferring step may include: bonding a portion of the plurality of light emitting diode chips coupled to the second manufacturing substrate to a transferring plate having a plurality of adhesive transferring portions; coupling a portion of the plurality of light emitting diode chips bonded to the transferring plate to the substrate; and separating the transferring plate from the plurality of light emitting diode chips coupled to the substrate.

In this case, an interval between the plurality of light emitting diode chips formed on the first manufacturing substrate may be same as an interval bewteen sub-pixels.

Alternatively, an interval between the plurality of first and second substrate electrodes may be same as the interval between sub-pixels.

Herein, forming the plurality of light emitting diode chips may include: forming a first conductivity type semiconductor layer, an active layer and a second conductivity type semiconductor layer on the first substrate; exposing a portion of the first conductivity type semiconductor layer; forming first and second electrodes on the first and second conductivity type type semiconductor layers, respectively; forming an encapsulant to cover the first and second electrodes; and forming first and second bumps electrically connected to the first and second electrodes on the encapsulant..

A method of manufacturing a display apparatus in accordance with one aspect of the present invention includes: forming a plurality of light emitting diode chips on a first manufacturing substrate; and transferring at least a portion of the plurality of light emitting diode chips formed on the first manufacturing substrate to a substrate on which a plurality of first and second substrate electrodes are disposed.

In addition, the method of manufacturing the display apparatus may further include: irradiating the first manufacturing substrate with a laser to separate the plurality of light emitting diode chips from the first manufacturing substrate, wherein the transferring step may include transferring a portion of the plurality of light emitting diode chips partially separated by the laser to the substrate.

In this case, the transferring step may include: coupling at least the portion of the plurality of light emitting diode chips formed on the first manufacturing substrate to the first and second substrate electrodes, and separating the first manufacturing substrate from at least the portion of the plurality of light emitting diode chips coupled to the substrate.

Herein, forming the plurality of light emitting diode chips includes: forming a light emitting structure including a first conductivity type semiconductor layer, an active layer and a second conductivity type semiconductor layer on the first substrate; exposing a portion of the first conductivity type semiconductor layer; forming first and second electrodes on the first and second conductivity type semiconductor layers, respectively; forming an encapsulant to cover the light emitting structure and the first and second electrodes; and forming first and second bumps electrically connected to the first and second electrodes on the encapsulant.

Moreover, the encapsulant is formed to continuously cover the first manufacturing substrate to be connected to an adjacent light emitting diode chip.

Moreover, an interval between the plurality of first and second substrate electrodes may be same as an interval between sub-pixels.

### [Advantageous Effects]

According to embodiments of the present invention, even when luminous area of a light emitting diode chip is reduced and an amount of the supplied current is small, there is an effect that the current density flowing through the light emitting diode chip may be increased.

In addition, by increasing a size of a light emitting diode package to be larger than a size of the light emitting diode chip, there is an effect that the yield of the manufacturing process of a display apparatus and the replacement process for repairing may be increased, even when the light emitting diode chip having a small luminous area is used.

### [Description of Drawings]

FIGs. 1A through 1H are views showing a method of transferring a light emitting diode chip of a display apparatus to a substrate not forming part of the invention.
FIGs. 2A through 2I are views showing a method of transferring a light emitting diode chip of a display apparatus to a substrate not forming part of the invention.
FIGs. 3A through 3I are views showing a method of transferring a light emitting diode chip of a display apparatus to a substrate not forming part of the invention.
FIGs. 4A through 4I are views showing a method of transferring a light emitting diode chip of a display apparatus to a substrate not forming part of the invention.
FIGs. 5A through 5D are views showing a method of transferring a light emitting diode chip of a display apparatus to a substrate according to an embodiment of the present invention.
FIGs. 6A through 6G are views showing a method of manufacturing a light emitting diode chip according to an embodiment of the present invention.

### [Mode for Invention]

Hereinafter, exemplary embodiments of the present disclosure will be described in detail with reference to the accompanying drawings.

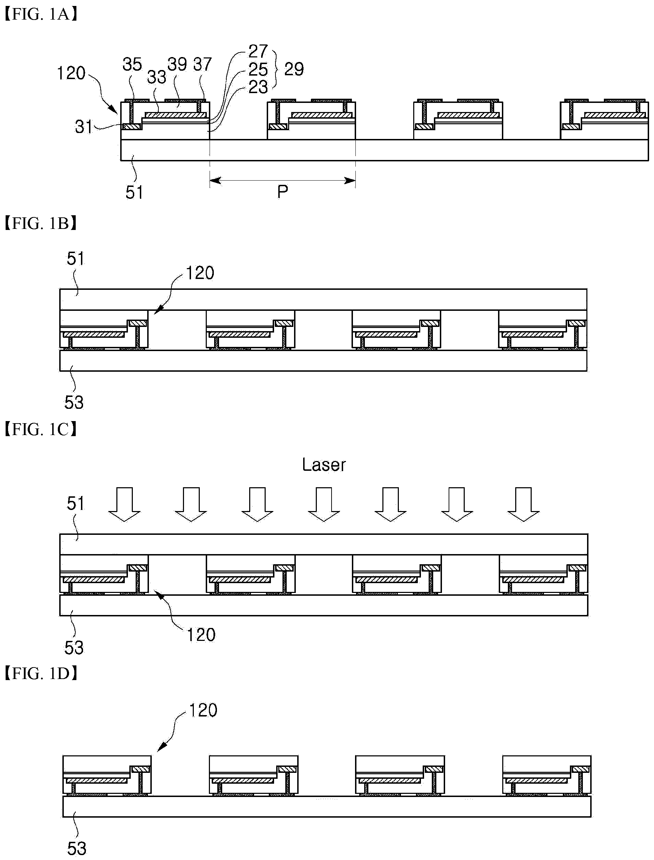

FIGs. 1A through 1H are views showing a method of transferring a light emitting diode chip of a display apparatus to a substrate not forming part of the invention.

Referring to FIG. 1A through 1H, the method of transferring a light emitting diode chip 120 to a substrate 110 in the display apparatus not forming part of the inventionwill be described.

Referring to FIG. 1A, a plurality of light emitting diode chips 120 are disposed on a first manufacturing substrate 51. In this case, the plurality of light emitting diode chips 120 may be transferred from the outside to the first manufacturing substrate 51, or the plurality of light emitting diode chips 120 may be grown and manufactured on the first manufacturing substrate 51. Herein, the first manufacturing substrate 51 may have an insulating material as the substrate 110, and may have a predetermined thickness.

The plurality of light emitting diode chips 120 may be spaced apart from one another at a predetermined interval P on the first manufacturing substrate 51. In this case, the interval P between the light emitting diode chips 120 may be an interval between subpixels of the display apparatus.

Each of the light emitting diode chips 122 may emit light by an external power source, and include a light emitting structure 29, an n-type electrode 31, a p-type electrode 33, an n-type bump 35, a p-type bump 37 and an encapsulant 39. The light emitting structure 29 may include an n-type semiconductor layer 23, an active layer 25 and a p-type semiconductor layer 27.

Each of the n-type semiconductor layer 23, the active layer 25 and the p-type semiconductor layer 27 may include Group III-V based compound semiconductors. By way of example, each of the n-type semiconductor layer 23, the active layer 25 and the p-type semiconductor layer 27 may include nitride semiconductors such as (Al, Ga, In)N. The n-type semiconductor layer 23 may be interchangeably placed with the p-type semiconductor layer 27.

The n-type semiconductor layer 23 may be a conductive semiconductor layer containing n-type dopants (for example, Si), and the p-type semiconductor layer 27 may be a conductive semiconductor layer containing p-type dopants (for example, Mg). The active layer 25 is interposed between the n-type semiconductor layer 23 and the p-type semiconductor layer 27, and may include a multi-quantum well (MQW) structure. The composition of the active layer 25 may be determined to emit light having a desired peak wavelength.

A structure of the light emitting structure 29 will be described, where the n-type semiconductor layer 23 is disposed thereunder, and the active layer 25 and the p-type semiconductor layer 27 are disposed over the n-type semiconductor layer 23 in the stated order. In addition, a portion of the n-type semiconductor layer 23 may be exposed upward by partially removing the p-type semiconductor layer 27 and the active layer 25.

The p-type electrode 33 is disposed over the p-type semiconductor layer 27 to be electrically connected to the p-type semiconductor layer 27, and the n-type electrode 31 is disposed over the exposed portion of the n-type semiconductor layer 23 to be electrically connected to the n-type semiconductor layer 23. That is, in this exemplary embodiment, the light emitting diode chip 122 may have a horizontal structure in which the n-type electrode 31 and the p-type electrode 33 are arranged in the same direction.

The encapsulant 39 may be disposed on an upper portion of the light emitting structure 29 to cover the n-type electrode 31, the p-type electrode 33 and the light emitting structure 29. The encapsulant 39 exhibits electrically insulating properties and may protect the light emitting structure 29, the n-type electrode 31 and the p-type electrode 33 from external environments. In this exemplary embodiment, the encapsulant 39 may be formed of a transparent material. Alternatively, the encapsulant 39 may be formed of an opaque material or a translucent material, as needed. Here, the encapsulant 39 may have a same width as the light emitting structure 29.

Each of the n-type bump 35 and the p-type bump 37 may be disposed to cover a portion of an upper surface of the encapsulant 39. In addition, the n-type bump 35 may be electrically connected to the n-type electrode 31, and the p-type bump 37 may be electrically connected to the p-type electrode 33 through via-holes passing through the encapsulant 39. The n-type bump 35 and the p-type bump 37 are spaced apart from each other on the upper surface of the encapsulant 39 to be electrically insulated from each other.

In a state in which the plurality of light emitting diode chips 120 is disposed on the first manufacturing substrate 51 as described above, the first manufacturing substrate 51 is turned upside down and the plurality of light emitting diode chips 120 are coupled to the second manufacturing substrate 53 as shown in FIG. 1B. Accordingly, the n-type bumps 35 and the p-type bumps 37 of the plurality of light emitting diode chips 120 are in contact with the second manufacturing substrate 53.

As shown in FIG. 1C, irradiation is performed over the first manufacturing substrate 51 with a laser. The first manufacturing substrate 51 and the plurality of light emitting diode chips 120 may be separated by irradiation.

Thus, as shown in FIG. 1D, the plurality of light emitting diode chips 120 may be transferred to the second manufacturing substrate 53.

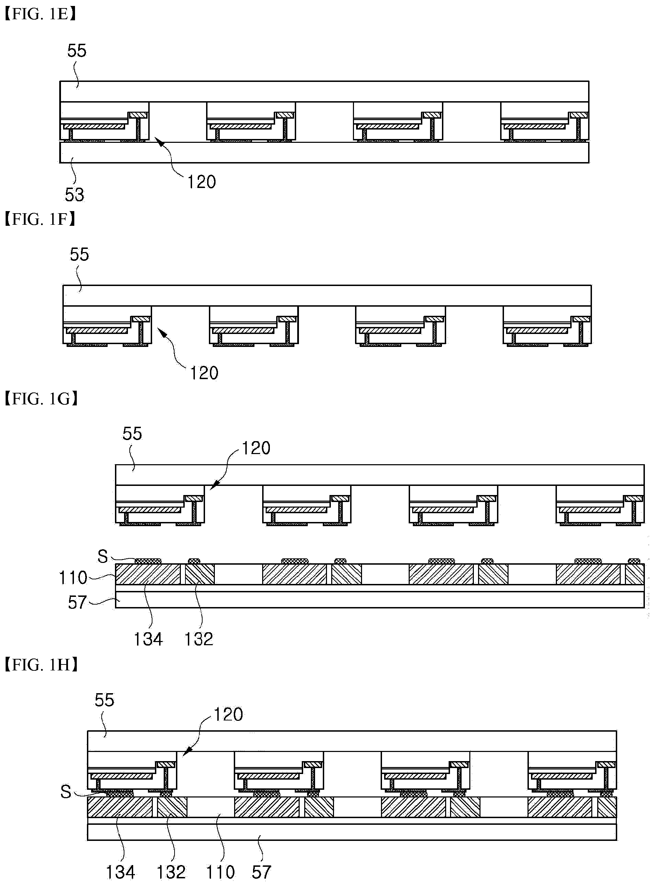

Referring to FIG. 1E, a third manufacturing substrate 55 is coupled to an upper portion of the plurality of light emitting diode chips 120. When the third manufacturing substrate 55 is coupled to the plurality of light emitting diode chips 120, the second manufacturing substrate 53 is removed as shown in FIG. 1F.

Herein, the second manufacturing substrate 53 and the third manufacturing substrate 55 may be the same as the first manufacturing substrate 51.

Referring to FIG. 1G, the plurality of light emitting diode chips 120 coupled to the third manufacturing substrate 55 may be transferred to the substrate 110. The substrate 110 is provided to support the light emitting diode chip 120, may have an insulating material, and may have a predetermined thickness.

Moreover, a first substrate electrode 132 and a second substrate electrode 134 may be disposed on the substrate 110. The first substrate electrode 132 may extend from an upper surface of the substrate 110 to a lower surface thereof, and the second substrate electrode 134 may also extend from the upper surface of the substrate 110 to the lower surface thereof. The first substrate electrode 132 and the second substrate electrode 134 may be spaced apart and electrically insulated from each other.

In addition, a fourth manufacturing substrate 57 may be disposed under the substrate 110, and a buffer layer may be formed between the substrate 110 and the fourth manufacturing substrate 57. The fourth manufacturing substrate 57 may have the same material as the first manufacturing substrate 51, and may be used in a subsequent process.

Also, a bonding portion S may be applied on the first substrate electrode 132 and the second substrate electrode 134.

Thus, the p-type bumps 37 and the n-type bumps 35 of the light emitting diode chip 120, as shown in FIG. 1H, are electrically coupled to the first substrate electrode 132 and the second substrate electrode 134, respectively. When the light emitting diode chip 120 is coupled to the substrate 110, the third manufacturing substrate 55 disposed over the plurality of light emitting diode chips 120 may be removed.

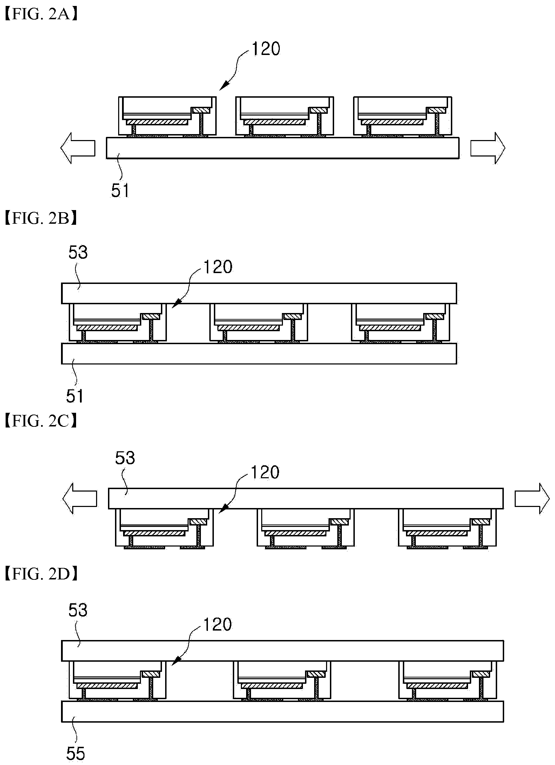

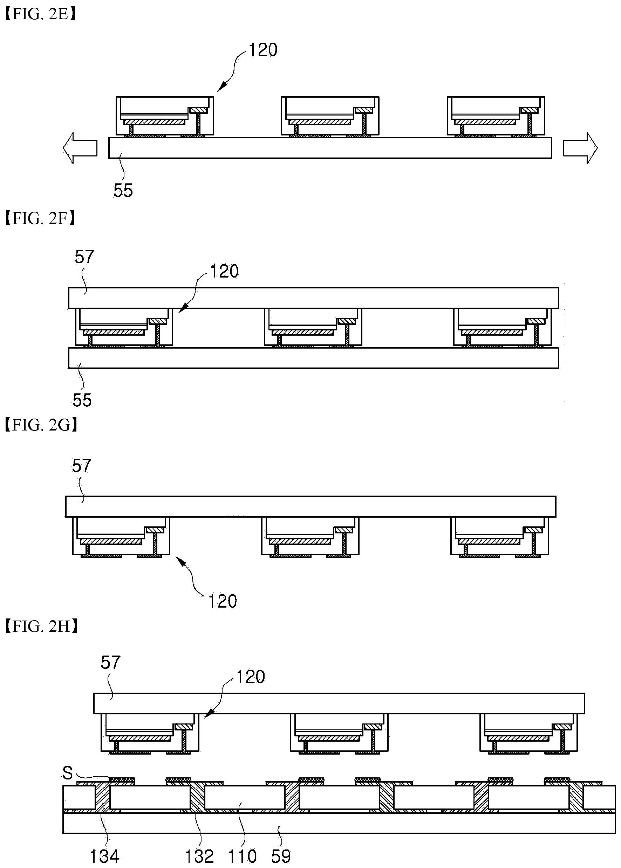

FIGs. 2A through 2I are views showing a method of transferring a light emitting diode chip of a display apparatus to a substrate not forming part of the invention.

Referring to FIGs. 2A through 2I, the method of transferring a light emitting diode chip 120 to the substrate 110 in the display apparatus not forming part of the inventionwill be described.

Referring to FIG. 2A, a plurality of light emitting diode chips 120 are disposed on a first manufacturing substrate 51. In this embodiment, the first manufacturing substrate 51 may have a material different from the first manufacturing substrate 51 in the first embodiment. The process of disposing the plurality of light emitting diode chips 120 on the first manufacturing substrate 51 of the present embodiment may be performed after the process of FIGs. 1A to 1D in the first embodiment.

Herein, the first manufacturing substrate 51 may be formed of an insulating material having elasticity. The first manufacturing substrate 51 may be elongated in the longitudinal direction. Accordingly, a distance between the plurality of light emitting diode chips 120 may be larger.

In this state, as shown in FIG. 2B, a second manufacturing substrate 53 is coupled to an upper portion of the plurality of light emitting diode chips 120. In this case, the second manufacturing substrate 53 may have an insulating material having elasticity as the first manufacturing substrate 51.

Referring to FIG. 2C, the first manufacturing substrate 51 is separated from the plurality of light emitting diode chips 120, the second manufacturing substrate 53 is elongated in the longitudinal direction, and a distance between the plurality of light emitting diode chips may be increased.

In a state that the distance between the plurality of light emitting diode chips 120 becomes larger by elongating the second manufacturing substrate 53, as shown in FIG. 2D, a third manufacturing substrate 55 is coupled to the plurality of light emitting diode chips 120.

Then, as shown in FIG. 2E, the second manufacturing substrate 53 is separated from the plurality of light emitting diode chips 120, and the third manufacturing substrate 55 is elongated in the longitudinal direction to increase the distance between the plurality of light emitting diode chips 120. In this case, the third manufacturing substrate 55 may have an insulating material having elasticity as the first manufacturing substrate 51.

In a state that the third manufacturing substrate 55 is elongated, as shown in FIG. 2F, a fourth manufacturing substrate 57 is coupled to the plurality of light emitting diode chips 120. Then, as shown in FIG. 2G, the third manufacturing substrate 55 is separated.

In a state that the plurality of light emitting diode chips 120 is coupled to the fourth manufacturing substrate 57, the fourth manufacturing substrate 57 may be coupled onto the substrate 110. In this case, a first substrate electrode 132 and a second substrate electrode 134 may be disposed on the substrate 110 as in the first embodiment. However, the first substrate electrode 132 and the second electrode have shapes different from those of the first embodiment. The first substrate electrode 132 extends from the upper surface of the substrate 110 to the lower surface thereof through the substrate 110. A portion of the first substrate electrode 132 is disposed on the upper surface of the substrate 110 and another portion of the first substrate electrode 132 is disposed on the lower surface of the substrate 110 such that both portions of the first substrate electrode 132 are electrically connected to each other through a via-hole formed in the substrate 110. As the first substrate electrode 132, portions of the second substrate electrode 134 are disposed on the upper and lower surfaces of the substrate 110, respectively, and are electrically connected to each other through the via-hole formed in the substrate 110. In this case, the first substrate electrode 132 may be spaced apart from the second substrate electrode 134 to be electrically insulated from each other.

The first substrate electrode 132 and the second substrate electrode 134 disposed on the upper surface of the substrate 110 may be electrically connected to an n-type bump 35 and a p-type bump 37, respectively, and a bonding portion S may be applied on the first substrate electrode 132 and the second substrate electrode 134 to be electrically coupled to the n-type bump 35 and the p-type bump 37, respectively.

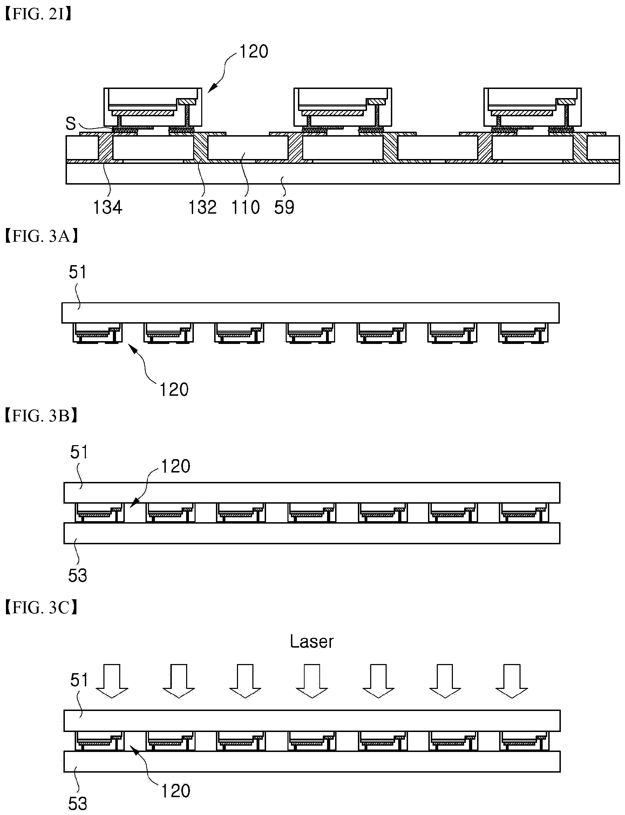

When the plurality of light emitting diode chips 120 are coupled to the substrate 110, the fourth manufacturing substrate 57, as shown in FIG. 2I, may be removed. A fifth manufacturing substrate 59 may be disposed under the substrate 110, and a buffer layer may be disposed between the substrate 110 and the fifth manufacturing substrate 59.

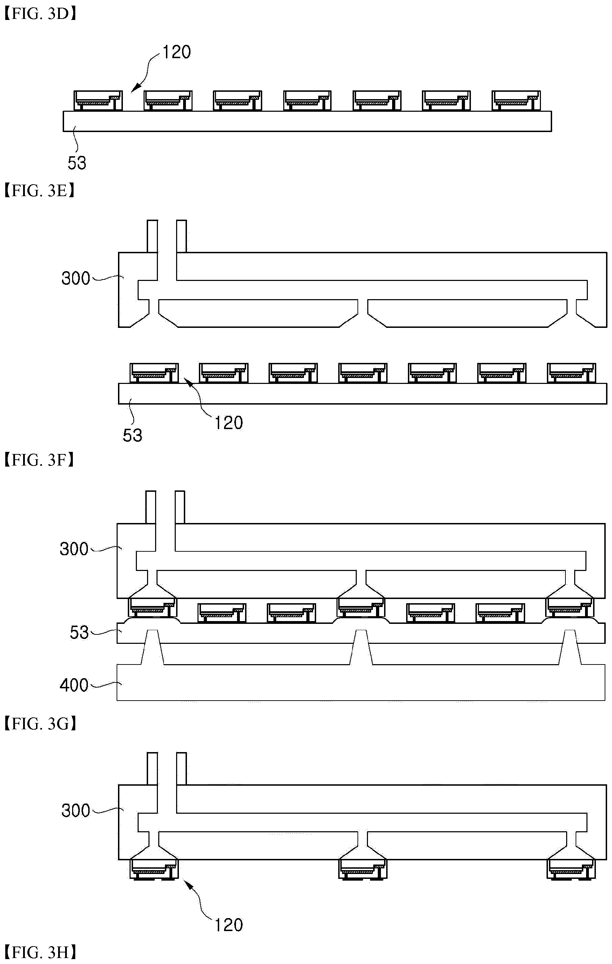

FIGs. 3A through 3I are views showing a method of transferring a light emitting diode chip of a display apparatus to a substrate not forming part of the invention.

Referring to FIGs. 3A through 3I, the method of transferring a light emitting diode chip 120 to the substrate 110 in the display apparatus not forming part of the inventionwill be described.

Referring to FIG. 3A, a plurality of light emitting diode chips 120 are disposed on a first manufacturing substrate 51. In this embodiment, the first manufacturing substrate 51 on which the plurality of light emitting diode chips 120 are disposed is the same as that of FIG. 1A in the first embodiment, but FIG. 3A may be a view showing a state in which the light emitting diode chip 120 is rotated by 180 degrees.

As shown in FIG. 3B, a second manufacturing substrate 53 is coupled to a lower portion of the plurality of light emitting diode chips 120, and irradiation is performed over the first manufacturing substrate 51 with a laser as shown in FIG. 3C. Accordingly, the plurality of light emitting diode chips 120 and the first manufacturing substrate 51 may be separated from each other.

FIG. 3D shows a state in which the plurality of light emitting diode chips 120 and the first manufacturing substrate 51 are separated from each other.

When the plurality of light emitting diode chips 120 are mounted on the second manufacturing substrate 53, a transfer device 300 is disposed upward to transfer a portion of the plurality of light emitting diode chips 120. The transfer device 300 may transfer the light emitting diode chips 120 from the second manufacturing substrate 53 to another location by absorbing the light emitting diode chips 120 disposed at predetermined intervals. In this case, the transfer device 300 may absorb the portion of the plurality of light emitting diode chips 120 disposed on the second manufacturing substrate 53 to transfer..

In the present embodiment, the transfer device 300 may adsorb one of the three adjacent light emitting diode chips 120 to transfer, but the number of the light emitting diode chips 120 to be transferred by the transfer device 300 may be varied as needed.

Then, as shown in FIG. 3F, when the transfer device 300 absorbs the plurality of light emitting diode chips 120, a heater 400 may operate under the corresponding light emitting diode chip 120. The heater 400 may heat and ultrasonic-vibrate the second manufacturing substrate 53 on which the light emitting diode chip 120 is disposed, to separate the light emitting diode chip 120 absorbed by the transfer device 300 from the second manufacturing substrate 53.

Accordingly, as shown in FIG. 3G, the plurality of light emitting diode chips 120 may be adsorbed to the transfer device 300.

The plurality of light emitting diode chips 120 absorbed to the transfer device 300 may be moved, and coupled to the substrate 110 as shown in FIG. 3H. Herein, a first substrate electrode 132 and a second substrate electrode 134 may be disposed on the substrate 110. In addition, a third manufacturing substrate 55 and a fourth manufacturing substrate 57 may be coupled to a lower portion of the substrate 110.

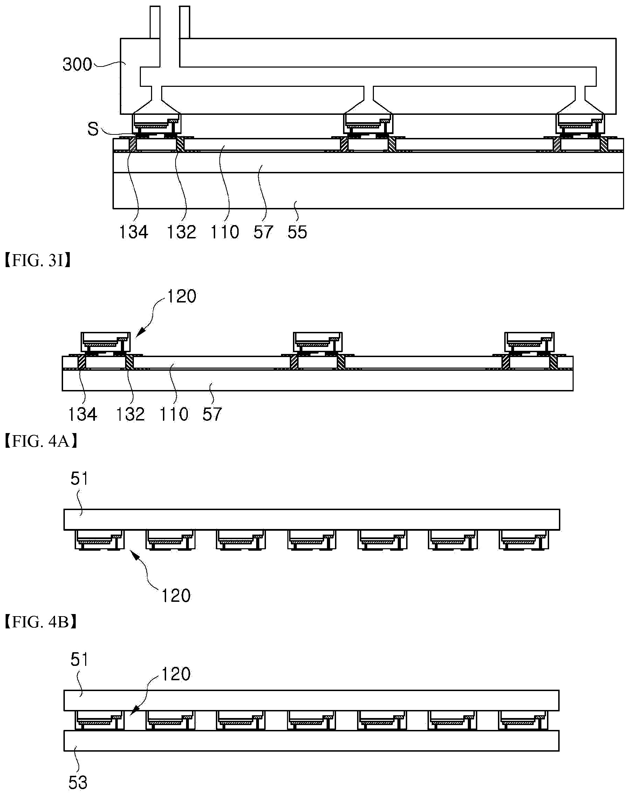

Then, as shown in FIG. 3I, the transfer device 300 is separated from the plurality of light emitting diode chips 120 coupled onto the substrate 110. In addition, the third manufacturing substrate 55 coupled to the lower portion of the fourth manufacturing substrate 57 may be heated to be separated.

In the present embodiment, each of the second manufacturing substrate 53, the third manufacturing substrate 55 and the fourth manufacturing substrate 57 may be the same as the first manufacturing substrate 51, and the first manufacturing substrate 51 may be the same as that in the first embodiment. Moreover, the third manufacturing substrate 55 may be provided to withstand the pressure that may be generated when the plurality of light emitting diode chips 120 are coupled to the substrate 110 from the transfer device 300.

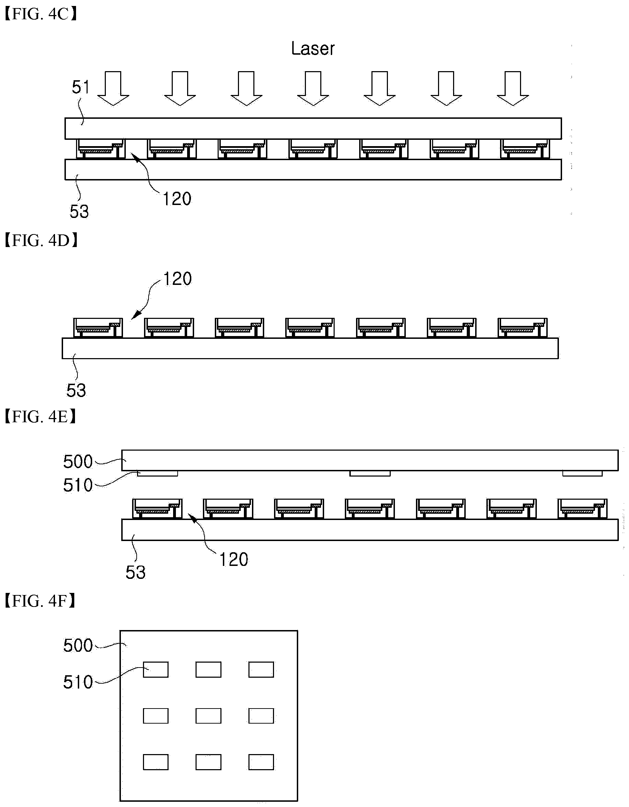

FIGs. 4A through 4I are views showing a method of transferring a light emitting diode chip of a display apparatus to a substrate not forming part of the invention.

Referring to FIGs. 4A through 4I, the method of transferring a light emitting diode chip 120 to the substrate 110 in the display not forming part of the invention will be described.

Referring to FIG. 4A, a plurality of light emitting diode chips 120 are disposed on a first manufacturing substrate 51. A process illustrated in FIGs. 4A through 4D is the same process as in the third embodiment, and a detailed description thereof will be omitted.

Referring to FIG. 4E, the plurality of light emitting diode chips 120 are disposed on a second manufacturing substrate 53, and a transferring plate 500 is disposed upward. The transferring plate 500 serves the same function as the transfer device 300 in the third embodiment. However, in this embodiment, the transferring plate 500 may include a plurality of adhesive transferring portion s 510. Accordingly, a portion of the plurality of light emitting diode chips 120 is bonded to the adhesive transferring portion 510, and is coupled to the transferring plate 500. The plurality of adhesive transferring portions 510 may be regularly disposed in the transferring plate 500 according to rows and columns as shown in FIG. 4F.

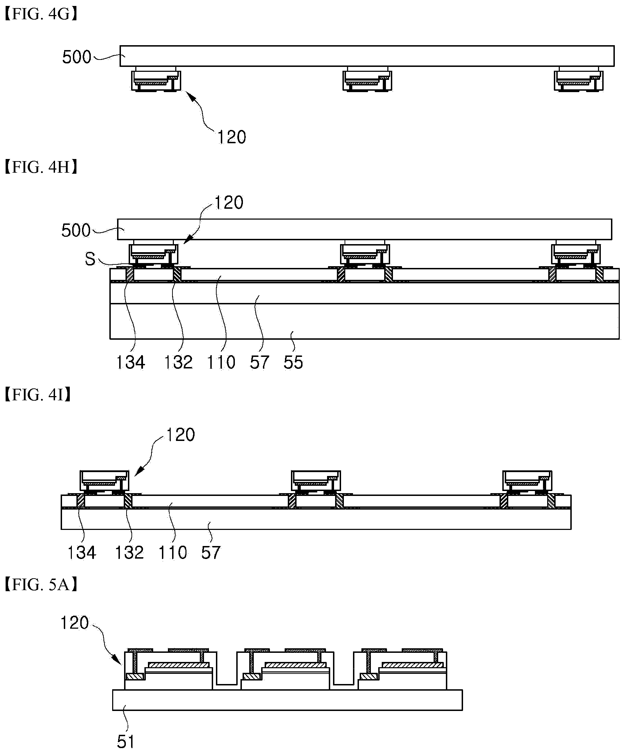

The plurality of light emitting diodes coupled to the transferring plate 500 in this manner is as shown in FIG. 4G.

The plurality of light emitting diode chips 120 bonded to the transferring plate 500, as shown in FIG. 4H, may be moved and coupled to the substrate 110. Then, as shown in FIG. 4I, the transferring plate 500 is separated from the plurality of light emitting diode chips 120. In this case, the substrate 110 is the same as that in the third embodiment, and a description thereof will be omitted.

FIGs. 5A through 5D are views showing a method of transferring a light emitting diode chip of a display apparatus to a substrate according to an embodiment of the present invention.

Referring to FIGs. 5A through 5D, the method of transferring a light emitting diode chip 120 to the substrate 110 in the display apparatus according to the embodiment of the present invention will be described.

Referring to FIG. 5A, a plurality of light emitting diode chips 120 are disposed on a first manufacturing substrate 51. In this embodiment, the plurality of light emitting diode chips 120 may be the same as in the first embodiment. However, if necessary, an encapsulant 39 of the light emitting diode chip 120 may be connected to an adjacent light emitting diode chip 120. Since the light emitting diode chip 120 is grown and manufactured on the first manufacturing substrate 51, the encapsulants 39 may be connected to each other between the adjacent light emitting diode chips 120 as shown in FIG. 5A.

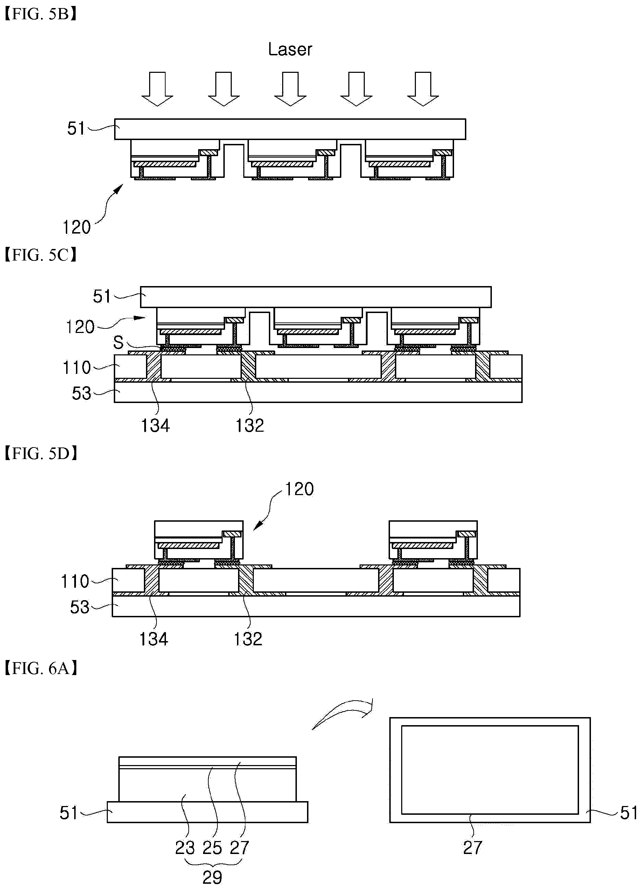

Then, as shown in FIG. 5B, the first manufacturing substrate 51 on which the plurality of light emitting diode chips 120 are disposed may be turned over to irradiate over the first manufacturing substrate 51. Accordingly, the first manufacturing substrate 51 and each light emitting diode chip 120 may be partially separated. At this time, an n-type semiconductor layer 23 of the light emitting diode chip 120 may be separated from the first manufacturing substrate 51 by irradiation with a laser, but each light emitting diode chip 120 may not be completely separated from the first manufacturing substrate 51 since the encapsulant 39 is connected to the adjacent light emitting diode chip 120.

In this state, referring to FIG. 5C, the first manufacturing substrate 51 is disposed on the substrate 110 so that a portion of the plurality of light emitting diode chips 120 is coupled to the substrate 110. At this time, a first substrate electrode 132 and a second substrate electrode 134 are disposed on the substrate 110 as in the second embodiment, and a bonding portion S may be applied on the first substrate electrode 132 and the second substrate electrode 134. As a result, the light emitting diode chip 120 in contact with the first substrate electrode 132 and the second substrate electrode 134 of the substrate 110 may be coupled onto the substrate 110.

That is, as shown in FIG. 5C, a plurality of first substrate electrodes 132 and the second substrate electrodes 134 disposed on the substrate 110 is not disposed at the same interval as that of the plurality of light emitting diode chips 120 disposed on the first manufacturing substrate 51. The plurality of first substrate electrodes 132 and the second substrate electrodes 134 may be disposed at an interval larger than that of the plurality of light emitting diode chips 120 disposed on the first manufacturing substrate 51. Accordingly, in a state in which the first manufacturing substrate 51 and the substrate 110 face each other, a portion of the plurality of light emitting diode chips 120 disposed on the first manufacturing substrate 51 may be disposed on the substrate 110.

Herein, since the bonding portion S is applied on the first substrate electrode 132 and the second substrate electrode 134, only the plurality of light emitting diode chips 120 coupled to the bonding portion S are coupled onto the substrate 110. In this embodiment, only one of the two light emitting diode chips 120 is shown to be coupled onto the substrate 110, but this may vary as needed.

Thus, as shown in FIG. 5D, the plurality of light emitting diode chips 120 may be disposed on the substrate 110. In this case, an interval of the plurality of light emitting diode chips 120 disposed on the substrate 110 may be an interval between sub-pixels of the display apparatus.

In addition, the substrate 110, in this embodiment, is the same as the substrate 110 in the second embodiment through the fourth embodiment, and a description thereof will be omitted.

FIGs. 6A through 6G are views showing a method of manufacturing a light emitting diode chip not forming part of the invention.

A process of manufacturing a light emitting diode chip 120 on a first manufacturing substrate 51 in the display apparatus will be described with reference to FIGs. 6A through 6G.

In FIGs. 6A through 6G, left drawings are sectional views, and right drawings are plan views.

Referring to FIG. 6A, an n-type semiconductor layer 23, an active layer 25 and a p-type semiconductor layer 27 are grown on the first manufacturing substrate 51.

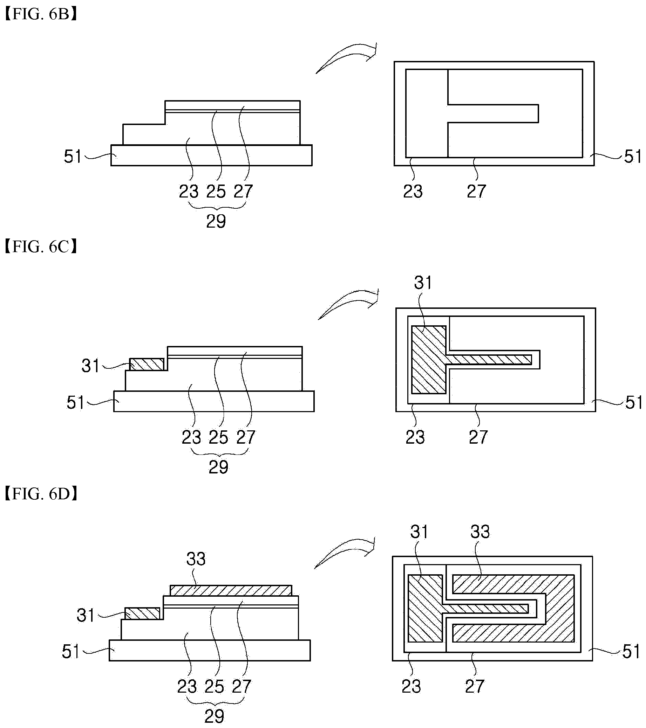

Subsequently, as shown in FIG. 6B, the active layer 25 and the p-type semiconductor layer 27 are partially removed to expose the n-type semiconductor layer 23 upward. In this case, the n-type semiconductor layer 23 exposed upward may be exposed in a T-shape as shown in the plan view of FIG. 6B.

Then, an n-type electrode 31 is formed on the exposed n-type semiconductor layer 23 as shown in FIG. 6C. The n-type electrode 31 may be also formed in a T-shape as the exposed n-type semiconductor layer 23. The n-type electrode 31 may be spaced apart from the active layer 25 and the p-type semiconductor layer 27 to be insulated.

Next, as shown in FIG. 6D, a p-type electrode 33 is formed over the p-type semiconductor layer 27. In this case, the p-type electrode 33 may be formed in a left-opened rectangular shape as the shape of the upper surface of the p-type semiconductor layer 27.

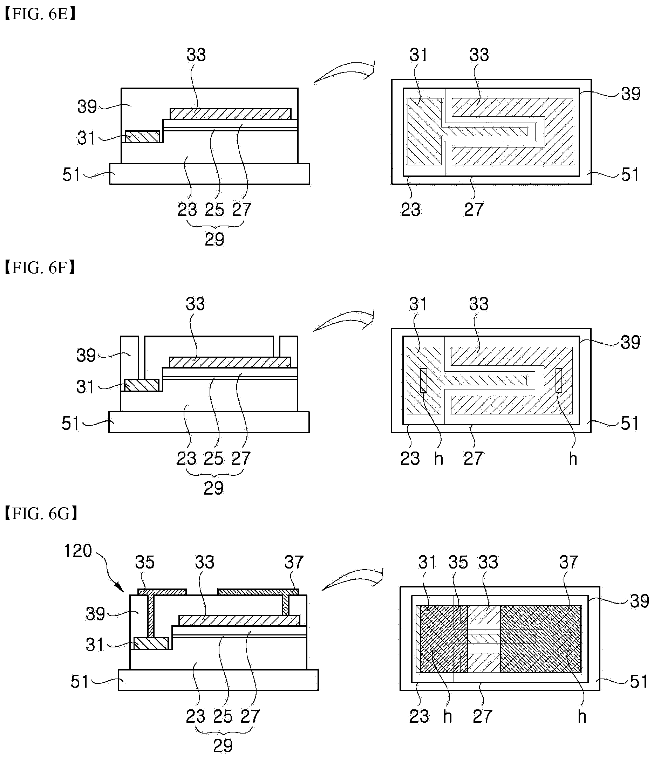

Then, referring to FIG. 6E, an encapsulant 39 may be formed to cover all of the n-type electrode 31, the p-type electrode 33 and the light emitting structure 29. The encapsulant 39 is formed to have the same width as that of the light emitting structure 29. Accordingly, the encapsulant 39 may not cover side surfaces of the light emitting structure 29.

Next, referring to FIG. 6F, a portion of the encapsulant 39 is etched to form a via exposing the n-type electrode 31 and the p-type electrode 33. At this time, the n-type electrode 31 and the p-type electrode 33 exposed through the via may be a portion of the n-type electrode 31 and the p-type electrode 33, respectively.

Then, referring to FIG. 6G, an n-type bump 35 and a p-type bump 37 are formed over the encapsulant 39, respectively. The n-type bump 35 is formed over the n-type electrode 31, and the p-type bump 37 is disposed over the p-type electrode 33. The n-type bump 35 may be electrically connected to the n-type electrode 31 through the via formed in the encapsulant 39, and the p-type bump 37 may be electrically connected to the p-type electrode 33 through the via formed in the encapsulant 39.

The light emitting diode chip 120 may be manufactured on the first manufacturing substrate 51 according to the manufacturing methods as described above.

Although some exemplary embodiments have been described herein, it should be understood by those skilled in the art that these embodiments are given by way of illustration only, and that various modifications, variations, and alterations can be made without departing from the scope of the present invention which is defined by the appended claims.

### */ Description of Reference Numerals

| | | | |
|---|---|---|---|
| 110: | substrate | | |
| 120: | light emitting diode chip | | |
| 23: | n-type semiconductor layer | 25: | active layer |
| 27: | p-type semiconductor layer | 29: | light emitting structure |
| 31: | n-type electrode | 33: | n-type electrode |
| 35: | n-type bump | 37: | p-type bump |
| 39: | encapsulant | | |
| 51: | first manufacturing substrate | 53: | second manufacturing substrate |
| 55: | third manufacturing substrate | 57: | fourth manufacturing substrate |
| 59: | fifth manufacturing substrate | | |
| 132: | first substrate electrode | 134: | second substrate electrode |
| 300: | transfer device | 400: | heater |
| 500: | transferring plate | 510: | adhesive transferring portion |
| S: | bonding portion | | |

## Claims

1. A method of manufacturing the display apparatus, comprising:
forming a plurality of light emitting diode chips (120) on a first manufacturing substrate (51); and
transferring at least a portion of the plurality of light emitting diode chips formed on the first manufacturing substrate to a substrate (110) on which a plurality of first (132) and second substrate electrodes (134) are disposed,
wherein forming the plurality of light emitting diode chips comprises:
forming a light emitting structure (29) including a first conductivity type semiconductor layer (23), an active layer (25) and a second conductivity type semiconductor layer (27) on the first substrate;
exposing a portion of the first conductivity type semiconductor layer;
forming first (31) and second electrodes (33) on the first and second conductivity type semiconductor layers, respectively;
forming an encapsulant (39) to cover the light emitting structure and the first and second electrodes; and
forming first (35) and second bumps (37) electrically connected to the first and second electrodes on the encapsulant, wherein the encapsulant is formed to continuously cover the first manufacturing substrate to be connected to an adjacent light emitting diode chip.

2. The method of manufacturing the display apparatus of claim 1, further comprising:
irradiating the first manufacturing substrate with a laser to separate the plurality of light emitting diode chips from the first manufacturing substrate,
wherein the transferring step comprises transferring a portion of the plurality of light emitting diode chips partially separated by the laser to the substrate.

3. The method of manufacturing the display apparatus of claim 1, wherein the transferring step comprises
coupling the at least a portion of the plurality of light emitting diode chips formed on the first manufacturing substrate to the first and second substrate electrodes, and
separating the first manufacturing substrate from at least the portion of the plurality of light emitting diode chips coupled to the substrate.

4. The method of manufacturing the display apparatus of claim 1,
wherein an interval between the plurality of first and second substrate electrodes is same as an interval between sub-pixels.

## Patentansprüche

1. Verfahren zur Herstellung einer Anzeigevorrichtung, aufweisend:
Bilden einer Vielzahl von Leuchtdiodenchips (120) auf einem ersten Fertigungssubstrat (51), und
Übertragen mindestens eines Teils der Vielzahl von Leuchtdiodenchips, die auf dem ersten Fertigungssubstrat gebildet wurden, auf ein Substrat (110), auf dem eine Vielzahl von ersten (132) und zweiten Substratelektroden (134) angeordnet sind,
wobei das Bilden der Vielzahl von Leuchtdiodenchips umfasst:
Bilden einer Leuchtstruktur (29) mit einer ersten leitfähigen Halbleiterschicht (23), einer Aktivschicht (25) und einer zweiten leitfähigen Halbleiterschicht (27) auf dem ersten Substrat,
Freilegen eines Teils der ersten leitfähigen Halbleiterschicht;
Bilden einer ersten (31) und einer zweiten Elektrode (33) auf der ersten bzw. zweiten leitfähigen Halbleiterschicht,
Bilden einer Einkapselung (39), um die Leuchtstruktur und die erste und zweite Elektrode zu bedecken, und Bilden von ersten (35) und zweiten erhöhten Kontaktierungsflecken (37), die elektrisch mit der ersten und zweiten Elektrode auf der Einkapselung verbunden sind, wobei die Einkapselung so ausgebildet ist, dass sie das erste Fertigungssubstrat, das mit einem benachbarten Leuchtdiodenchip verbunden werden soll, kontinuierlich bedeckt.

2. Das Verfahren gemäß Anspruch 1, ferner aufweisend:
Bestrahlen des ersten Fertigungssubstrats mit einem Laser, um die Vielzahl der Leuchtdiodenchips vom ersten Fertigungssubstrat zu trennen,
wobei das Übertragen das Übertragen eines Teils der Vielzahl von Leuchtdiodenchips, die teilweise durch den Laser getrennt wurden, auf das Substrat umfasst.

3. Das Verfahren gemäß Anspruch 1, wobei das Übertragen aufweist
Verbinden mindestens eines Teils der auf dem ersten Fertigungssubstrat gebildeten Leuchtdiodenchips mit den ersten und zweiten Substratelektroden, und
Trennen des ersten Fertigungssubstrats von zumindest dem Teil der Vielzahl der Leuchtdiodenchips, die mit dem Substrat verbunden sind.

4. Das Verfahren gemäß Anspruch 1,
wobei ein Intervall zwischen der Vielzahl von ersten und zweiten Substratelektroden einem Intervall zwischen Subpixeln entspricht.

## Revendications

1. Procédé de fabrication du dispositif d'affichage, comprenant :
la formation d'une pluralité de puces de diode électroluminescente (120) sur un premier substrat de fabrication (51) ; et
le transfert d'au moins une partie de la pluralité de puces de diode électroluminescente formées sur le premier substrat de fabrication vers un substrat (110) sur lequel sont disposées une pluralité de premières (132) et secondes électrodes de substrat (134),
dans lequel la formation de la pluralité de puces de diode électroluminescente comprend :
la formation d'une structure électroluminescente (29) comprenant une première couche semi-conductrice de type conductivité (23), une couche active (25) et une seconde couche semi-conductrice de type conductivité (27) sur le premier substrat ;
l'exposition d'une partie de la première couche semi-conductrice de type conductivité ;
la formation d'une première (31) et d'une seconde électrodes (33) sur la première et la seconde couches semi-conductrices de type conductivité, respectivement ;
la formation d'un encapsulant (39) pour couvrir la structure électroluminescente et les première et seconde électrodes ; et
la formation d'une première (35) et d'une seconde bosses (37) électriquement reliées à la première et à la seconde électrodes sur l'encapsulant, dans lequel l'encapsulant est formé pour couvrir continuellement le premier substrat de fabrication à relier à une puce de diode électroluminescente adjacente.

2. Procédé de fabrication du dispositif d'affichage selon la revendication 1, comprenant en outre :
l'irradiation du premier substrat de fabrication avec un laser pour séparer la pluralité de puces de diode électroluminescente du premier substrat de fabrication,
l'étape de transfert consistant à transférer une partie de la pluralité de puces de diode électroluminescente partiellement séparées par le laser sur le substrat.

3. Procédé de fabrication du dispositif d'affichage selon la revendication 1, dans lequel l'étape de transfert comprend
le couplage d'au moins une partie de la pluralité de puces de diode électroluminescente formées sur le premier substrat de fabrication aux première et seconde électrodes du substrat, et
la séparation du premier substrat de fabrication d'au moins la partie de la pluralité de puces de diode électroluminescente couplées au substrat.

4. Procédé de fabrication du dispositif d'affichage selon la revendication 1,
dans lequel un intervalle entre la pluralité de première et seconde électrodes de substrat est identique à un intervalle entre les sous-pixels.
